# EUROPÄISCHE PATENTSCHRIFT

(11) **EP 2 075 835 B1**
(45) Veröffentlichungstag und Bekanntmachung des Hinweises auf die Patenterteilung: **27.05.2020**
(21) Anmeldenummer: 08105698.8
(22) Anmeldetag: 30.10.2008
(51) Int. Cl.: H01L 23/492

(54) **Diode mit Vorrichtungen zur Reduktion der mechanischen Spannung**
Diode with stress reducing means
Diode avec moyens pour la réduction de contraintes méchaniques

(30) Priorität: 28.12.2007 DE 102007063308
(43) Veröffentlichungstag der Anmeldung: 01.07.2009
(73) Patentinhaber: Robert Bosch GmbH, 70442 Stuttgart (DE)
(72) Erfinder: Spitz, Richard, 72766 Reutlingen (DE); Goerlach, Alfred, 72127 Kusterdingen (DE); Dietrich, Jochen, 91522 Ansbach (DE)

(56) Entgegenhaltungen:
- EP-A- 1 130 645
- WO-A-01/75963
- JP-A- 2002 319 659
- US-A1- 2005 127 134
- US-A1- 2006 138 532
- US-A1- 2007 298 244
- CHRISTIAN MERTENS ED - MERTENS CHRISTIAN: "Die Niedertemperatur-Verbindungstechnik der Leistungselektronik" DIE NIEDERTEMPERATUR-VERBINDUNGSTECHNIK DER LEISTUNGSELEKTRONIK; [FORTSCHRITT-BERICHTE VDI : REIHE 21, ELEKTROTECHNIK ; 365], VDI VERLAG, DÜSSELDORF, GERMANY, 1. Januar 2004 (2004-01-01), Seiten 1-35,72, XP002541611 ISBN: 978-3-18-336521-0
- DAS EUROPÄISCHE PARLAMENT UND DER RAT DER EUROPÄISCHEN UNION: "RICHTLINIE 2002/95/EG DES EUROPÄISCHEN PARLAMENTS UND DES RATES vom 27. Januar 2003 zur Beschränkung der Verwendung bestimmter gefährlicher Stoffe in Elektro- und Elektronikgeräten" AMTSBLATT DER EUROPÄISCHEN UNION, Nr. L37, 13. Februar 2003 (2003-02-13), XP002558112
- BAI GUOFENG: "Low-temperature sintering of nanoscale silver paste for semiconductor device interconnection", DISSERTATION SUBMITTED TO THE FACULTY OF THE VIRGINIA POLYTECHNIC INSTITUTE AND STATE UNIVERSITY IN PARTIAL FULFILLMENT OF THE REQUIREMENT FOR THE DEGREE OF DOCTOR OF PHILOSOPHY IN MATERIALS SCIENCE A , 1 October 2005 (2005-10-01), pages 1-195, XP009166994, Retrieved from the Internet: URL:http://scholar.lib.vt.edu/theses/avail able/etd-10312005-163634/ [retrieved on 2013-02-11]
- "CHAPTER 3: Uniaxiales Pressverfahren" In: "Aufbaukonzepte für die Leistungselektronik mit der Niedertemperatur-Verbindungstechnik (Book Series: Fortschritt-Berichte VDI)", 1 January 2006 (2006-01-01), VDI Verlag GmbH, XP055130828, ISBN: 978-3-18-337621-6 pages 27-57,

## Beschreibung

### Stand der Technik

Die Erfindung betrifft eine Diode mit einer bleifreien Verbindung die sich insbesondere als Diode für den Einsatz bei sehr hohen Temperaturen in Kfz-Generatorsystemen eignet.

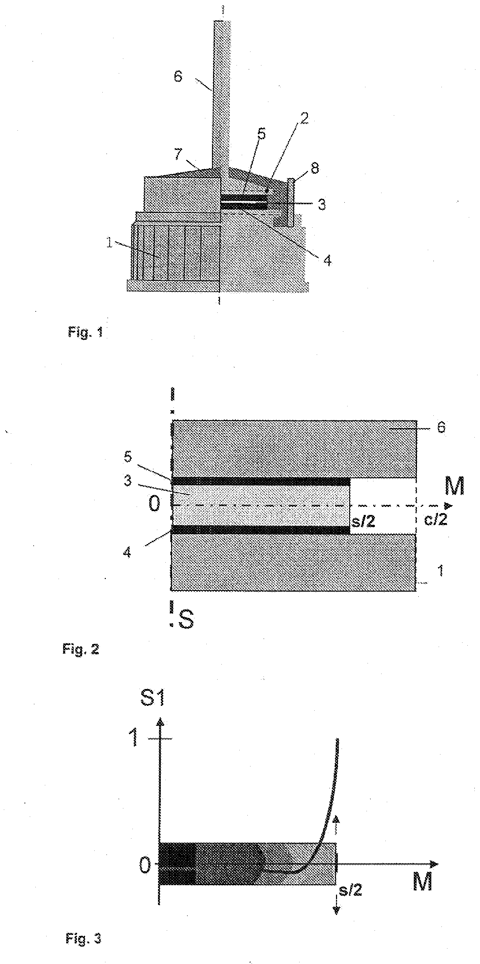

In Kfz-Generatorsystemen werden zur Gleichrichtung des Wechsel- bzw. Drehstroms meist Siliziumdioden eingesetzt. Dazu werden in der Regel Siliziumdioden in spezielle Gehäuse, in sogenannte Einpressgehäuse, montiert. Fig. 1 zeigt den typischen Aufbau einer solchen Einpressdiode. Die Einpressdioden weisen dabei einen mit einer Rändelung versehenen Einpresssockel (1) auf, der in eine entsprechende Aussparung einer Gleichrichteranordnung eingepresst wird. Der Einpresssockel übernimmt dabei gleichzeitig eine dauerhafte thermische und elektrische Verbindung der Gleichrichterdiode mit der Gleichrichteranordnung. Der Einpresssockel weist einen Befestigungsbereich auf, an dem ein Halbleiterchip beispielsweise durch Löten (4) befestigt ist. Auf dem Halbleiterchip wiederum ist ebenfalls beispielsweise durch Löten (5) ein sogenannter Kopfdraht (6) befestigt, der elektrisch beispielsweise durch Löten oder Schweißen fest mit anderen Komponenten des Gleichrichters kontaktiert ist. Der zwischen die zwei Kupferteile gelötete Siliziumchip ist mit einer isolierenden Kunststoffmasse umhüllt (7). Als Kunststoffmasse kann zum Beispiel ein mit Quarzkörnern gefülltes Epoxid oder ein sonstiger hoch temperaturfester Kunststoff dienen. Zur Einbringung der Kunststoffmasse (7) wird meist ein zusätzlicher Kunststoffring (8) angebracht. Meist befindet sich noch eine - in Fig. 1 nicht eingezeichnete - zusätzliche, weiche Kunststoffschicht zwischen Chip (3) und Epoxid (7). Die Kupferteile sind i. a. mit einer dünnen Oberflächenschicht aus Nickel versehen. Bis heute werden die Siliziumchips in der Regel mittels hoch bleihaltigen Loten auf bzw. zwischen die beiden Kupferteile gelötet. Die maximale Temperatur im Inneren der Einpressdiode ist durch den Schmelzpunkt des Lotes begrenzt. Bei hoch bleihaltigen Loten können deshalb Temperaturen bis etwa 300°C kurzzeitig beherrscht werden. Solche Dioden sind z. B. aus DE-19549202 bekannt.

Die Anforderungen an Einpressdioden in modernen Kfz-Gleichrichter steigen immer weiter an. So werden immer höhere Ströme bei gleichzeitig erhöhter Betriebszeit und Einsatztemperatur gefordert. Die Zuverlässigkeit einer bleihaltigen Lotverbindung nimmt aber mit zunehmender Einsatztemperatur in Folge von vermehrter plastischer Verformung des Lotes ab. Es tritt sogenanntes Lotkriechen auf. Wegen seiner toxischen Eigenschaften sollte auf Blei als Konstruktionswerkstoff ganz verzichtet werden. Aus der Druckschrift Christian Mertens: "Die Niedertemperatur-Verbindungstechnik der Leistungselektronik" 2004, VDI-Verlag Düsseldorf,Germany, ist der Einsatz von Niedertemperatur-Verbindungstechnik im Zusammenhang mit der Herstellung von Bauteilen für die Leistungselektronik, beispielsweise auch für Dioden bekannt. Dabei wird beispielsweise mittels Niedertemperatur-Verbindungstechnik ein Silizium Halbleiterchip mit einem weiteren Bauteil dauerhaft und ohne bleihaltiges Lot verbunden. Eine Niedertemperatur-Verbindungsschicht, beispielsweise aus Silber stellt die Verbindung zwischen dem Chip und dem weiteren Bauteil, das z.B. aus Kupfer ist, her. Aus der US 2005/0127134 A1 sind Verfahren bekannt, bei denen eine temperaturfeste Verbindung zwischen einem Chip und einem weiteren Bauteil mittels einer Schicht, die Nano-Metall-Partikel, die in einem lange Ketten aufweisenden Polymer eingebunden sind, aufweisen. Aus der Druckschrift Guofen Bais : "Low-Temperature Sintering of Nanoscale Silver Paste for Semiconductor Device Interconnection", Oct 2005, Blacksburg, Virginia Polytechnic Institute and State University, ist der Einsatz von Unterbrechungen in einer zur Ausbrennen von von organische Rückständen während einer Niedertemperaturverbindungstechnik Befestigungsschritt bekannt. Aus der Druckschrift : "Aufbaukonzepte für die Leistungselektronik mit der Niedertemperatur-Verbindungstechnik" , Fortschritt-Berichte VDI, 1 Jan.2006, VDI Verlag GmbH, ist der Verbindung einer vertikalen Diode zwischen zwei DCB-Substraten unter Verwendung von Niedertemperaturverbindungstechnik bekannt.

### Offenbarung der Erfindung

Die Aufgabe der Erfindung besteht daher darin, die Nachteile der bleihaltigen Lotverbindung aufzuheben und ohne Blei als Konstruktionswerkstoff bzw. Lotverbindung auszukommen. Gelöst wird diese Aufgabe durch die in den Merkmalen des Anspruchs 1 vorgeschlagenen Maßnahmen.

Dabei wird in vorteilhafter Weise die hoch bleihaltige Lotverbindung bisheriger Dioden durch eine speziell aufgebrachte Silberschicht ersetzt. Als ein Maß für die Zuverlässigkeit einer Lotverbindung kann die homologe Temperatur T_{H} herangezogen werden. Sie ist als das Verhältnis von maximaler Bauteiltemperatur Tc und Schmelztemperatur des Lotes Ts - jeweils gemessen in Kelvin - definiert. Je niedriger die homologe Temperatur gewählt ist, desto zuverlässiger ist die Lotverbindung. Bei einer angenommenen Einsatztemperatur Tc = 498K verringert sich die homologe Temperatur von TH=0,86 auf TH=0,4, wenn an statt eines hoch bleihaltigen Lotes eine Silberschicht verwendet wird. Im Gegensatz zu einem bleihaltigen Weichlot, bei dem das Lot während des Fügeprozesses aufgeschmolzen werden muss, kann der Fügeprozess bei einer Silberschicht in vorteilhafter Weise schon bei Temperaturen weit unterhalb der Schmelztemperatur erfolgen. Im allgemeinen erfolgt der Fügeprozess unter zusätzlichem mechanischem Druck. Die zu fügenden Teile wie Kopfdraht, Siliziumchip und Sockel müssen dazu mit einer dünnen Edelmetallbeschichtung versehen sein. Ein solches Verfahren ist prinzipiell bereits bekannt und wird beispielsweise in der EP 0 242 626 A beschrieben. Es wird meist als Niedertemperaturverbindungstechnik oder als NTV bezeichnet.

Im Vergleich zu hoch bleihaltigen Loten weisen die NTV-Schichten ein etwa dreifach höheres E-Modul auf. Die Zugfestigkeit ist sogar in vorteilhafter Weise etwa 5-mal höher. Da der thermische Ausdehnungskoeffizient von NTV-Schichten nur um etwa 20% geringer ist als von hoch bleihaltigen Loten, sind die Spannungen bei thermischen Belastungen eines Kupfer / NTV / Siliziumchip / NTV / Kupfer - Sandwichs wesentlich höher als bei herkömmlichen bleihaltigen Lotverbindungen. So sind bisher keine NTV-Verbindungen auf reinem Kupfer bekannt. Entweder wird zwischen Siliziumchip und Kupferteil noch eine dicke Molybdänschicht mittels NTV-Verbindungstechnik zum Spannungsabbau eingefügt, oder der Siliziumchip wird auf eine beidseitig mit Kupfer beschichtete Keramik mit geringerem Ausdehnungskoeffizient (DBC) montiert.

Mit den erfindungsgemäß vorgeschlagenen vorteilhaften Maßnahmen, können Halbleiterchips aus Silizium oder andern Halbleitermaterialien mittels NTV-Verbindungstechnik direkt mit Kupferteilen verbunden werden. Insbesondere ist es möglich eine Einpressdiode, bei der der Siliziumchip auf beiden Seiten mit Kupfer verbunden ist, auf besonders vorteilhafte Weise herzustellen.

Fig. 1 zeigt schematisch einen typischen Aufbau einer teilweise aufgeschnittenen Einpressdiode. Bei den erfindungsgemäß vorgeschlagenen Verbesserungsmaßnahmen wird im Wesentlichen der in Fig. 1 mit (2) bezeichnete Bereich so modifiziert, dass es möglich ist, einen Siliziumchip mittels NTV-Technik zwischen zwei Kupferteile (1) und (6) zu montieren. Grundsätzlich können die hier vorgeschlagenen konstruktiven Maßnahmen auch mit andern Verbindungstechniken als der NTV-Technik vorteilhaft kombiniert werden. Im Folgenden wird nur der Bereich (2) betrachtet. Der Einfachheit halber wird die elektrisch isolierende, gefüllte Kunststoffmasse (7) nicht eingezeichnet. Fig. 2 stellt den betrachteten Ausschnitt einer Einpressdiode gemäß Figur 1 nochmals im Detail als Querschnittszeichnung dar. Dabei ist nur der Teil aus Figur 1 dargestellt, der sich rechts der Spiegelachse S befindet. Die Darstellung ist nicht maßstäblich gezeichnet. M bezeichnet eine Mittellinie, die vom Chipmittelpunkt 0 aus genau in der Mitte des Siliziumchips verläuft. Die Chipkante befindet sich bei s/2, das Ende der Kupferteile bei c/2. Der Halbleiterchip (3) ist mittels einer NTV-Schicht (5), mit einem oberen Kupferteil (6) und mit einer NTV-Schicht (4) mit einer unteren Kupferschicht (1) verbunden. Die NTV-Schichten (4) und (5) sind beispielsweise mittels eines NTV-Verfahrens aufgebrachte Silberschichten. In einem Beispiel, das nicht unter die beanspruchte Erfindung fällt, können statt Silber auch andere geeignete Stoffe Edelmetalle eingesetzt werden.

Beim NTV-Verbindungsprozess (Niedertemperaturverbindungstechnik) werden die zu verbindenden Teile zusammengefügt und unter Druck Temperaturen beispielsweise 200°C - 300°C ausgesetzt. Beim anschließenden Abkühlen ziehen sich die Teile in Folge der unterschiedlichen Ausdehnungskoeffizienten verschieden stark zusammen. Dadurch wird bei einer Anordnung nach Fig. 2 eine starke Kraft auf den Siliziumchip ausgeübt. Da sich die Kupfer- und die NTV-Schichten wesentlich mehr zusammenziehen als das Silizium treten am Chiprand sehr hohe Zugkräfte auf. Diese Kräfte können zu einer Zerstörung des Siliziumchips führen. Numerische thermomechanische Simulationen zeigen, dass bei einem Siliziumchip mit 20 mm² Chipfläche, 200 µm Chipdicke und einer NTV-Dicke von 30 - 400 µm mechanische Spannungen von über 200 MPa auftreten können. Bei diesen Spannungen können bereits Risse im Silizium auftreten, die mit der erfindungsgemäßen Lösung, die den auftretenden mechanischen Stress mindert, zu vermeiden sind.

In Fig. 3 ist der Spannungsverlauf der Hauptspannung S1 entlang der Mittellinie M schematisch dargestellt. Die maximale Zugspannung S1 tritt an der Chipkante s/2 auf. Zur Veranschaulichung ist die Chipgeometrie mit dem betrag der Hauptspannung S1 hinterlegt und die Kraftrichtung am Chiprand mittels Pfeilen angedeutet. Zugspannungen weisen positive und Druckspannungen negative Werte auf. Die zerstörende Spannung S1 ist bei der Darstellung nach Figur 3 auf 1 normiert. Durch die in dieser Erfindung vorgeschlagenen Maßnahmen wird die maximal auftretende Spannung S1 auf für einen Halbleiterchip unkritische Werte reduziert.

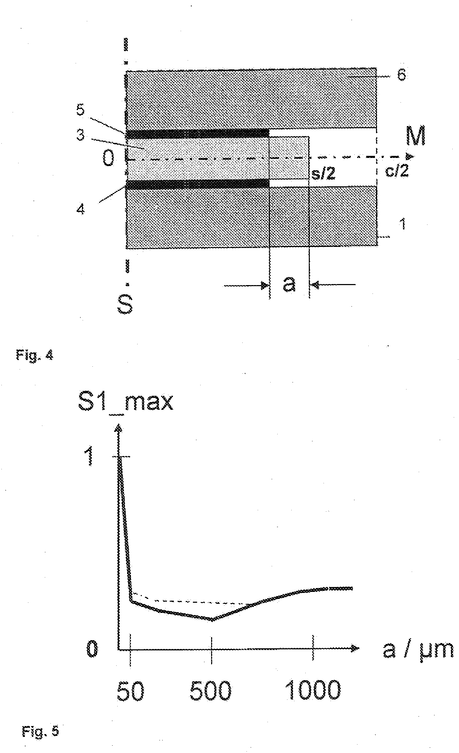

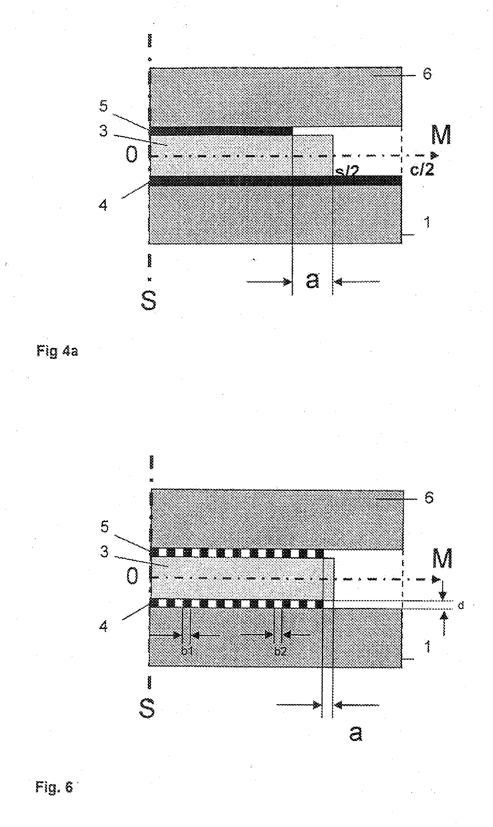

In Fig. 4 ist ist ein Beispiel, das nicht unter die beanspruchte Erfindung fällt aufgezeigt, mit einer Anordnung zur Reduktion der mechanischen Spannungen auf einen Halbleiterchip. Dieses Ausführungsbeispiel ist wie auch die weiteren Ausführungsbeispiele geeignet für in Niedertemperaturverbindungstechnik erzeugte NTV-Schichten, insbesondere Silberschichten, da die durch den NTV-Prozess auftretenden Spannungen auf den Chip geeignet reduziert werden.

Im Gegensatz zu einer herkömmlichen Anordnung reichen die in Niedertemperaturverbindungstechnik erzeugten NTV-Schichten (4) und (5) nicht mehr bis zur Chipkante, sondern sind an allen Stellen um einen Abstand a von der Chipkante zurückgezogen. Im Gegensatz zu einer Anordnung gemäß Fig. 1 sinkt die maximal im Halbleiterchip auftretende Spannung schnell ab. So ist die maximale Spannung S1 an der Chipkante bei einem 20 mm² großen, 200 µm dicken Siliziumchip (bei a = 0) auf einen unkritischen Wert abgefallen.

In Fig. 5 ist der Verlauf des Maximums der ersten Hauptspannung S1_max entlang der Mitte eines Siliziumchips als Funktion des Abstandes a für zwei unterschiedliche NTV-Dicken skizziert. Beispielhaft ist der Chip 20 mm² groß und 200 µm dick. Die durchgezogene Linie steht für eine NTV-Dicke von 100 µm und die gestrichelte Linie für 400 µm. Grundsätzlich ist es möglich, die obere NTV-Schicht 5 und die untere NTV-Schicht 4 unterschiedlich dick auszuführen.

Ein besonders einfaches Beispiel, das nicht unter die beanspruchte Erfindung fällt, mit einer vorteilhaften Anordnung zur Reduktion der mechanischen Spannung auf einen Halbleiterchip ist in Fig. 4a dargestellt. Dabei wird die NTV-Schicht nur an einer Seite vom Siliziumchip zurückgezogen, während auf der anderen Seite die NTV-Schicht sogar über den Chip hinausragen kann. Die maximale Hauptspannung S1 wird dabei etwa auf ein Drittel des Wertes reduziert.

Ein Ausführungsbeispiel mit einer Anordnung zur Reduktion der mechanischen Spannung auf einen laut der Erfindung ist im Querschnitt in Figur 6 dargestellt. Die Dicke der NTV-Schichten ist mit d, die Breite der NTV-Bereiche mit b1 und der Abstand zwischen den inneren NTV-Bereichen mit b2 bezeichnet. Der Abstand a beschreibt wie weit der äußerste NTV-Bereich von der Siliziumkante zurückgezogen ist. Im Gegensatz zum Beispiel nach Fig. 4 sind beim Ausführungsbeispiel nach Figur 6 die NTV Schichten nicht nur um den Abstand a von der Chipkante zurückgezogen, sondern weisen auch noch mindestens eine kreisförmig umlaufende Unterbrechung im Innern der NTV-Schichten auf. Durch diese Maßnahme können die maximal auftretenden Spannungen im Siliziumchip weiter vorteilhaft reduziert werden. Es ist u. U. damit möglich, den äußeren Abstand a auf 0 zu reduzieren, bzw. die NTV-Schicht sogar über den Chiprand hinaus erstrecken zu lassen.

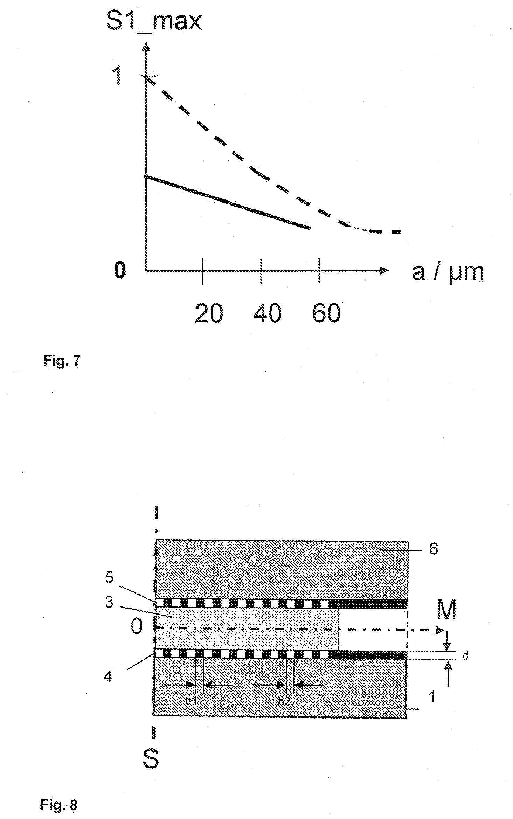

Figur 7 beschreibt den Verlauf der Hauptspannung S1_max in Chipmitte eines 20 mm² großen und 200 µm dicken Siliziumchips nach Figur 6 für eine NTV-Dicke von 45 µm (durchgezogen) und 100 µm (gestrichelt) in Abhängigkeit vom Abstand a für den Fall, dass die NTV-Schichtdicke d und die Breite der NTV-Schichten b1 ist und der Abstand b2 zwischen den NTV-Schichten gleich ist (45 µm oder 100 µm).

Es ist zu erkennen, dass die maximale Hauptspannung S1_max in Chipmitte unter den kritischen - auf 1 normierten Wert - absinkt. Natürlich können die Bereiche b1 und b2 auch anders gewählt werden. So kann b1 auch größer oder kleiner als b2 sein. Die Weiten b1 und b2 müssen über den Verlauf des Chips auch nicht konstant bleiben, sondern können im Abstand variieren oder sich auch nur in bestimmten Bereichen der Siliziumoberfläche befinden. In einem Beispiel, das nicht unter die beanspruchte Erfindung fällt, kann die Form der Unterbrechungen der NTV-Schicht (Abstand b2) unterschiedlich ausgeführt sein. Z. B. kann die Form rechteckig umlaufend oder aber auch nichtumlaufend (Löcherform) sein. Außerdem können die NTV-Dicken auf Ober- und Unterseite des Chips verschieden gewählt sein.

Fig. 8 zeigt eine mögliche Variante einer Ausführungsform der Erfindung, bei der die NTV-Schicht sogar auf beide Seiten über den Chiprand bzw. die Halbleiterchipkante hinausreicht. Die Dicke der NTV-Schichten ist dabei mit d, die Breite mit b1 und der Abstand zwischen den NTV-Bereichen mit b2 bezeichnet.

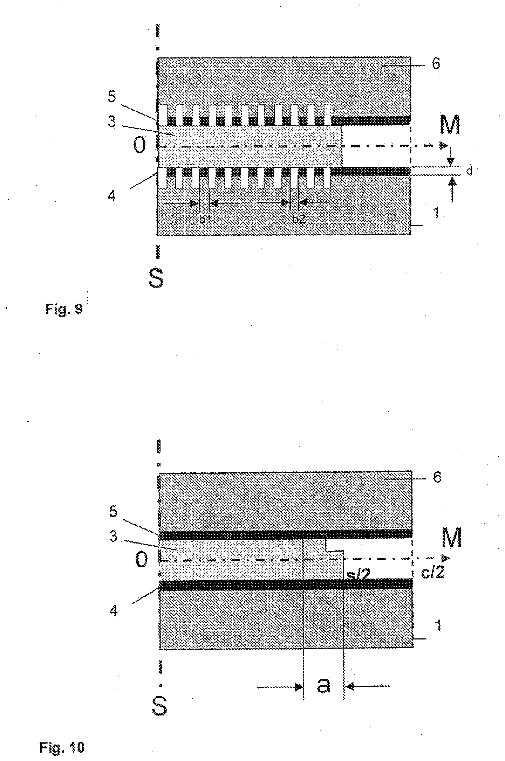

Weitere Beispiele, die nicht unter die beanspruchte Erfindung fällt, mit Anordnungen zur Reduktion der mechanischen Spannungen auf einen Halbleiterchip sind in den Fig. 9 und 10 aufgezeigt. Die Anordnung gemäß Fig. 9 ähnelt dem Aufbau aus Fig. 8, allerdings sind jetzt zusätzlich Vertiefungen in dem oberen Kupferteil (6) und in dem unteren Kupferteil (1) angebracht. Durch diese Maßnahme wird die auftretende maximale Hauptspannung S1_max in Chipmitte ebenfalls auf unkritische Werte reduziert. Selbstverständlich sind auch bei dieser Variante weitere Ausformungen, wie Variation der Weiten b1 und b2, Form der ausgesparten Bereiche usw. möglich.

In einem Beispiel, das nicht unter die beanspruchte Erfindung fällt, gemäß Fig. 10 erlaubt ebenfalls einen besonders einfachen Herstellungs- bzw. Fügeprozess. Dabei wird auf das Zurückziehen der NTV-Schicht ganz verzichtet und stattdessen eine Aussparung im Siliziumchip angebracht. Diese kann auf unterschiedliche Weise, z. B. durch Ätzen, Einsägen oder sonst einem geeigneten Verfahren schon auf Waferebene, d. h. beim Halbleiterherstellungsprozesses erfolgen. Durch geeignete Wahl der Abmessungen kann die maximale Hauptspannung im Chip leicht auf ein Viertel des Wertes, der ohne eine Maßnahme auftritt, gesenkt werden. Es ist beispielsweise möglich, dass diese Aussparung im Silizium auch auf beiden Seiten (Vorder- und Rückseite) angebracht werden kann und dass damit die vorteilhafte Wirkung weiter erhöht wird. Selbstverständlich sind auch bei dieser Variante weitere Ausformungen, wie Variation der Weiten b1 und b2, Form der ausgesparten Bereiche usw. möglich.

## Patentansprüche

1. Diode mit einem Siliziumhalbleiterchip der durch in Niedertemperaturverbindungstechnik hergestellte NTV-Schichten (4, 5) beidseitig, bleifrei, hochtemperaturfest und großflächig mit Kupferteilen verbunden ist, wobei die NTV-Schichten aus Silber bestehen, **dadurch gekennzeichnet, dass** sich die NTV-Schichten (4, 5), die den Siliziumhalbleiterchip (3) mit den Kupferteilen (1,6) verbinden, innerhalb der Siliziumflächen des Siliziumhalbleiterchip (3) befinden und mindestens eine kreisförmig umlaufende Unterbrechung aufweisen.

2. Diode nach Anspruch 1 **dadurch gekennzeichnet, dass** die NTV-Schichten (4) über den Rand des Chips (3) hinausragen.

3. Diode nach einem der vorhergehenden Ansprüche **dadurch gekennzeichnet, dass** sie eine Einpressdiode für Gleichrichter für Kfz-Drehstromgeneratoren ist.

## Claims

1. Diode comprising a silicon semiconductor chip connected to copper parts on both sides, in a manner free of lead, in a manner resistant to high temperatures and over a large area by means of NTC layers (4, 5) produced using low-temperature connection technology, wherein the NTC layers consist of silver, **characterized in that** the NTC layers (4, 5) connecting the silicon semiconductor chip (3) to the copper parts (1, 6) are situated within the silicon surfaces of the silicon semiconductor chip (3) and have at least one interruption extending circumferentially in a circular fashion.

2. Diode according to Claim 1, **characterized in that** the NTC layers (4) project beyond the edge of the chip (3).

3. Diode according to either of the preceding claims, **characterized in that** it is a press-fit diode for rectifiers for motor vehicle three-phase generators.

## Revendications

1. Diode comprenant une puce de silicium semi-conductrice qui est connectée des deux côtés, par des couches NTV (4, 5) fabriquées par une technique de connexion à basse température, sans plomb, de manière résistant aux hautes températures et sur une grande surface, avec des parties en cuivre, les couches NTV se composant d'argent, **caractérisée en ce que** les couches NTV (4, 5) qui relient la puce de silicium semi-conductrice (3) aux parties en cuivre (1, 6) se trouvent à l'intérieur des surfaces de silicium de la puce de silicium semi-conductrice (3) et présentent au moins une interruption périphérique circulaire.

2. Diode selon la revendication 1, **caractérisée en ce que** les couches NTV (4) font saillie au-delà du bord de la puce (3).

3. Diode selon l'une quelconque des revendications précédentes, **caractérisée en ce qu'**il s'agit d'une diode à insérer pour des redresseurs de générateurs de courant triphasé de véhicules automobiles.
